# EUROPEAN PATENT SPECIFICATION

(11) **EP 1 115 899 B1**
(45) Date of publication and mention of the grant of the patent: **12.04.2006**
(21) Application number: 99946693.1
(22) Date of filing: 27.08.1999
(51) Int. Cl.: C23C 14/34, B23K 31/00, B23K 20/02, B23K 20/22, B21D 39/03

(54) **LOW TEMPERATURE SPUTTER TARGET BONDING METHOD AND TARGET ASSEMBLIES PRODUCED THEREBY**
VERBINDUNGSVERFAHREN FÜR EIN NIEDRIGTEMPERATURSPUTTERTARGET UND SO HERGESTELLTES NIEDRIGTEMPERATURSPUTTERTARGET
PROCEDE DE LIAISON D'UNE CIBLE DE PULVERISATION CATHODIQUE BASSE TEMPERATURE ET ENSEMBLES CIBLES PRODUITS SELON CE PROCEDE

(30) Priority: 11.09.1998 US 99981 P; 16.04.1999 US 129559 P
(43) Date of publication of application: 18.07.2001
(73) Proprietor: TOSOH SMD, INC., Grove City, Ohio 43123-1895 (US)
(72) Inventor: IVANOV, Eugene, Y., Grove City, OH 43123 (US); CONARD, Harry, W., Orient, OH 43146 (US)
(74) Representative: Bankes, Stephen Charles Digby
(86) International application number: PCT/US1999/019869
(87) International publication number: WO 2000/015863

(56) References cited:
- JP-A- 2 043 362
- JP-A- 6 081 142
- US-A- 2 262 074
- US-A- 3 324 544
- US-A- 4 652 358
- US-A- 4 968 665
- US-A- 5 009 765
- US-A- 5 226 469
- US-A- 5 230 459
- US-A- 5 342 496
- US-A- 5 397 050
- US-A- 5 415 754
- US-A- 5 593 082
- US-A- 5 653 856
- US-A- 5 676 803
- US-A- 5 693 203
- US-A- 5 803 342
- US-A- 5 836 506
- US-A- 5 879 524
- PATENT ABSTRACTS OF JAPAN vol. 0072, no. 81 (C-200), 15 December 1983 (1983-12-15) & JP 58 157968 A (KOUJIYUNDO KAGAKU KENKYUSHO:KK), 20 September 1983 (1983-09-20)
- PATENT ABSTRACTS OF JAPAN vol. 0142, no. 02 (C-0713), 25 April 1990 (1990-04-25) & JP 2 043362 A (HITACHI METALS LTD), 13 February 1990 (1990-02-13)

## Description

The present application pertains to a low temperature sputter target/backing plate bonding method according to the preamble of claim 1 and to a combination of sputter target and backing plate made thereby according to the preamble of claim 16.

### Background of the Invention

Cathodic sputtering is widely used for the deposition of thin layers of material onto desired substrates. Basically, this process requires gas ion bombardment of a target having a face formed of a material that is to be deposited as a thin film or layer on a substrate. Ion bombardment of the target not only causes atoms or molecules of the target material to be sputtered, but imparts considerable thermal energy to the target. This heat is dissipated by use of a cooling fluid typically circulated beneath or around a heat conducting backing plate that is positioned in heat exchange relation with the target.

The target forms a part of a cathode assembly which together with an anode is placed in an evacuated chamber that contains an inert gas, preferably argon. A high voltage electrical field is applied across the cathode and anode. The inert gas is ionized by collision with the electrons ejected from the cathode. Positively charged gas ions are attracted to the cathode and, upon impingement with the target surface, dislodge the target material. The dislodged target materials traverse the evacuated enclosure and deposit as a thin film on the desired substrate that is normally located proximate the anode.

In addition to the use of an electrical field, increasing sputtering rates have been achieved by the concurrent use of an arch-shaped magnetic field that is superimposed over the electrical field and formed in a closed loop configuration over the surface of the target. These methods are known as magnetron sputtering methods. The arch-shaped magnetic field traps electrons in an annular region adjacent the target surface thereby increasing the number of electron-gas atom collisions in the area to produce an increase in the number of positively charged gas ions in the region that strike the target to dislodge the target material. Accordingly, the target material becomes eroded (i.e., consumed for subsequent deposition on the substrate) in a generally annular section of the target face, known as the target raceway.

In conventional target cathode assemblies, the target is attached to a nonmagnetic backing plate. The backing plate is normally water-cooled to carry away the heat generated by the ion bombardment of the target. Magnets are typically arranged beneath the backing plate in well-known disposition in order to form the above-noted magnetic field in the form of a loop or tunnel extending around the exposed face of the target.

In order to achieve good thermal and electrical contact between the target and backing plate, these members are commonly attached to each other by means of soldering, brazing, diffusion bonding, clamping and by epoxy cement and the like.

In some prior art target/backing plate assemblies, projections formed in either the interfacial surfaces of the target or backing plate are received in corresponding recesses or grooves of the other member to improve thermal conductivity. For example in Hillman U.S. Patent No. 4,885,075, annularly arranged members of high thermal conductivity protrude from either the target or backing plate into a corresponding recess formed in the other member. Upon heating of the target during sputtering, the protruding members expand radially to make contact with the recess wall to thereby improve heat transfer between the target and backing plate.

Elastic and plastic deformation of backing plate members in target/backing plate cathode assemblies is minimized in accordance with U.S. Patent 5,269,899 (Fan), of common assignment herewith, by the provision of mating teeth like projections disposed along the target/backing plate interfacial surfaces, with the mating surface of the backing plate having a concave surface. Here again, upon heating of the target, the target teeth expand radially and make snug contact with the mating teeth on the backing member to enhance thermal conductivity.

U.S. Patent 5,230,459 (Mueller et al.) of common assignment herewith, on which the preambles of claims 1 and 16 are based, teaches the use of diffusion bonding methods wherein one of the target/backing plate mating surfaces is first prepared with grooves or the like. During the diffusion bonding process, jagged portions of the grooves penetrate into the metal from the opposed interfacial surface and disrupt the formation of oxide and other bond inhibiting layers that may otherwise form along the target/backing plate interface to thereby improve bonding efficacy. The method results in a strong bond with increased shear resistance such that the assembly can withstand thermal stress that otherwise may tend to result in debonding or target warpage during use.

JP-A-58157968 discloses a process for producing a sputtering target wherein a metallic plate, for example of copper, has a surface comprising hollows and projections, the projections being wider at the top than at the bottom and the hollow being wider at the bottom. A sputtering target is formed by casting a low melting metal such as tin, indium alloy or lead on to this surface, so that when it solidifies it meshes with the projections and hollows, securely bonding the target material to the plate.

US-A-5009765 discloses a cathode sputtering assembly wherein a sputter target is welded around its periphery to an annular backing member. The target and the backing member are both made of aluminium and define between them a peripheral V-shaped groove which is filled with an aluminium filler rod whereby the target and backing member are TIG welded together.

US-A-5226469 discloses a process for manufacturing a rail by joining a first material, which is preferably magnetically permeable and has a first joining surface in which recesses having overhang surfaces are formed, to a second material preferably made of an electrically conductive material and having a second joining surface to be joined to the first joining surface. The second joining surface has integrally formed thereon protrusions having an outer configuration which enables them to enter the recesses of the first material. By heat pressing the two materials together, the protrusions on the second surface can be deformed to assume the shape of the recesses into which they are inserted, thereby locking the two materials together.

In those cases in which diffusion bonding of Al, Cu, or other low melting point targets have been tried, the heat needed for the diffusion bonding process causes an undesirable growth in grain size. Accordingly, there is a need in the art to provide a low temperature target bonding method so that target grain size can be accurately controlled and maintained at a desired minimal size.

The present invention provides a method of preparing a bonded sputter target/backing plate assembly comprising a target composed of a metal or alloy to be sputtered and an under-lying metallic backing plate member according to claim 1.

In a preferred method according to the invention, a target and backing plate are provided wherein the harder metal of the two is machined or otherwise formed so as to have a plurality of ridges or other salient surface portions thereof. These ridges or salient portions are formed along the interior surface space of the target or backing plate. The ridged surface is then placed alongside the mating surface of the other member of the assembly along a target/backing plate interface wherein bonding will occur.

The peripheral portion of the interfacial surface of the assembly is bonded by conventional means such as E-beam welding, TIG welding, friction welding, etc, preferably under vacuum. The assembly is then pressed together at a low temperature, such as room temperature, so that the target and backing plate are in contact to improve thermal conductivity of the assembly.

The projections or ridges formed along either the target or backing plate penetrate into the mating metal surface along the target/backing plate interface. These projections penetrate the softer metal on the opposing mating surface breaking through the oxide surface thereon. This results in a metal to metal cold diffusion type bond with the projections bending as a result of the cold pressing and forming a mechanical interlocking mechanism.

After the cold pressing operation, a low temperature annealing can be performed on the assembly to enhance adherence of the mating surfaces.

The present invention provides a combination of sputter target and backing plate according to claim 16.

The invention will be further described in conjunction with the attached drawings and following detailed description. In the drawings:

### Brief Description of the Drawings

Figure 1 is a cross-sectional view of the preferred target/backing plate assembly in accordance with the-invention, prior to the low temperature pressure consolidation step;
Figure 2 is a cross-sectional view, similar to Fig. 1, of an example of a combination of target and backing plate made using the method of the invention;
Figure 3 is a cross-sectional view, similar to Fig.1, of another example of a combination of target and backing plate made using the method of the invention;
Figure 4 is a cross-sectional view of the target/backing plate assembly shown in Fig. 1, taken after bonding of the assembly by the low temperature pressure consolidation step in accordance with the invention;
Figure 5 is a cross-sectional view similar to Fig. 4 but showing the example of Fig. 2 in its bonded position;
Figure 6 is a cross-sectional view similar to Fig. 4 but showing the example of Fig. 3 in its bonded position;
Figure 7 is a schematic drawing of a photomicrograph taken showing a magnified view of a portion of the target/backing plate interface of the Fig. 4 embodiment;
Figure 8 is a magnified view of a portion of the target/backing plate interface encircled in Fig. 5;
Figure 9 is a magnified view of a portion of the target/backing plate interface encircled in Fig. 6; and
Figure 10 is a top plan view of the backing plate shown in the Fig. 1 embodiment.

### Detailed Description of the Preferred Embodiment

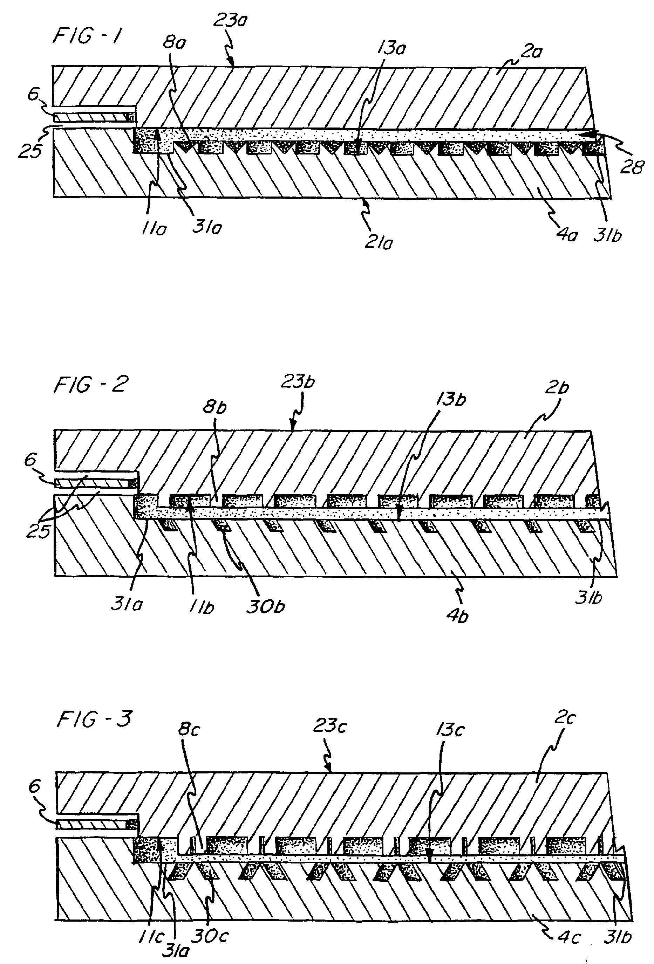

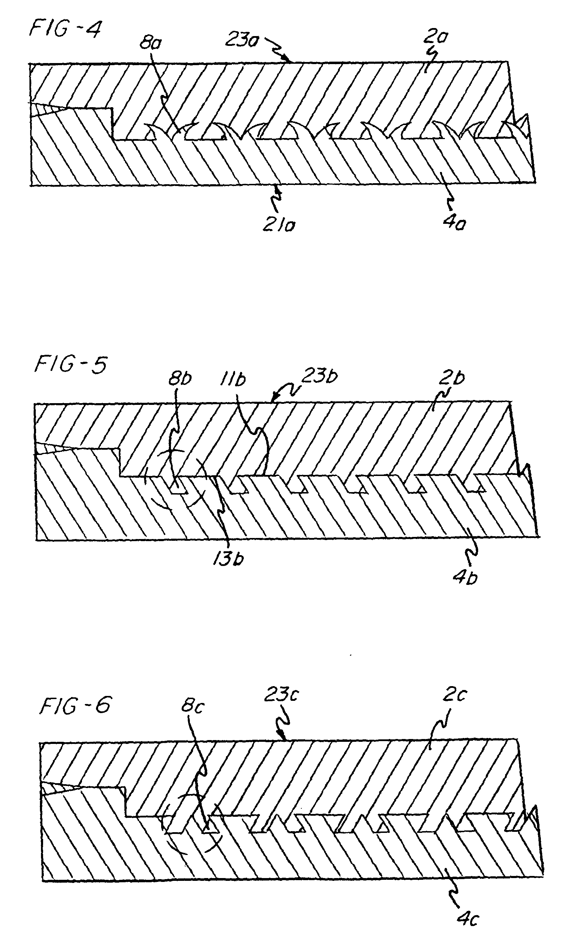

Turning first to figures 1 and 4, there is shown a first embodiment of a target/backing plate assembly in accordance with the invention. The assembly comprises a target 2a having a top side 23a carrying metal or metal alloy that, in accordance with conventional sputtering methods, will be ejected from the target 2a via ionic bombardment and will travel to and coat the desired substrate.

A backing plate 4a is provided under the target 2a, with the bottom side 11a of the target 2a adapted to mate with the top side 13a of the backing plate 4a to define an interfacial surface area 28. A generally horizontal plane exists through the points 31a, 31 b, along this interfacial surface area 28 and serves as the location where the interfacial surfaces will be joined upon bonding. Commonly, a heat exchange fluid such as water is circulated adjacent the bottom side 21 a of the backing plate 4a so as to cool the assembly during its sputtering operation.

In some cases, it is desired to provide a filler material 6, such as an Al-4%Si alloy or other suitable alloy, in the form of a ring or the like, adjacent the peripheral border of the assembly between the target and backing plate. The filler material 6 enhances bonding of the target 2a to the backing plate 4a as shall be explained hereinafter. Alternatively, the filler material 6 may be omitted.

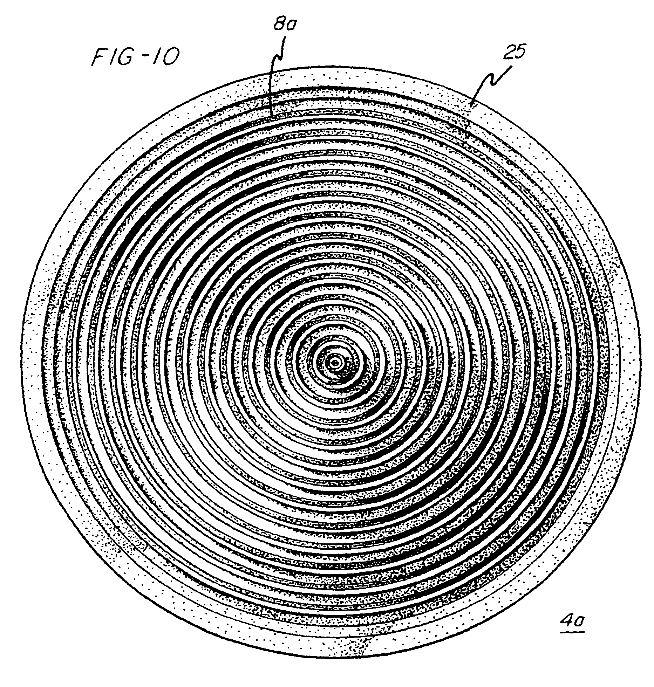

A plurality of salient portions 8a, shown in the drawing as "M" - shaped ridges or projections are machined into either one of the surfaces 11a or 13a depending on whether the target 2a or backing plate 4a is harder. Stated differently, the projections 8a are formed in the harder of the surfaces 11a or 13a. In this embodiment, the "M" cross-sectioned salient portions are machined into the top surface of the backing plate. As can be seen in Figure 10, the salient portions 8a are arranged in a plurality of concentrically arranged annular rows.

The assembly is first bonded around a band or zone adjacent the periphery of the target as designated by the number 25. This initial bonding along the peripheral border of the assembly may be achieved by conventional means such as by E-beam welding under vacuum conditions, TIG welding, and friction welding and the like. Preferably, the bonding of the peripheral boundaries of the target and backing plate is performed via E-beam welding under vacuum conditions.

The result of the peripheral bonding is that a strong target/backing plate bond is provided in this preipheral area 25 that surrounds the salient portions 8a of the assembly. After the peripheral bonding, the assembly is consolidated, via pressure application thereto, at pressures of about 50 tons - 5,000 tons; preferably less than about 1,000 tons, under low temperature conditions.

The projections 8a from the harder metal penetrate into the softer metal and disrupt the oxide film that may exist along the interface thereby promoting a metal to metal cold diffusion type bond.

After the low temperature pressure consolidation, the assembly may be subjected to a low temperature annealing step conducted at temperatures of about room to 200°C to 482°C for a period of 0.5 to 4 hours. This will help ensure adequate adhesion of the pressure consolidated surfaces.

The phrase "low temperature pressure consolidation" refers to pressure consolidation that occurs at less than 38 degrees C.

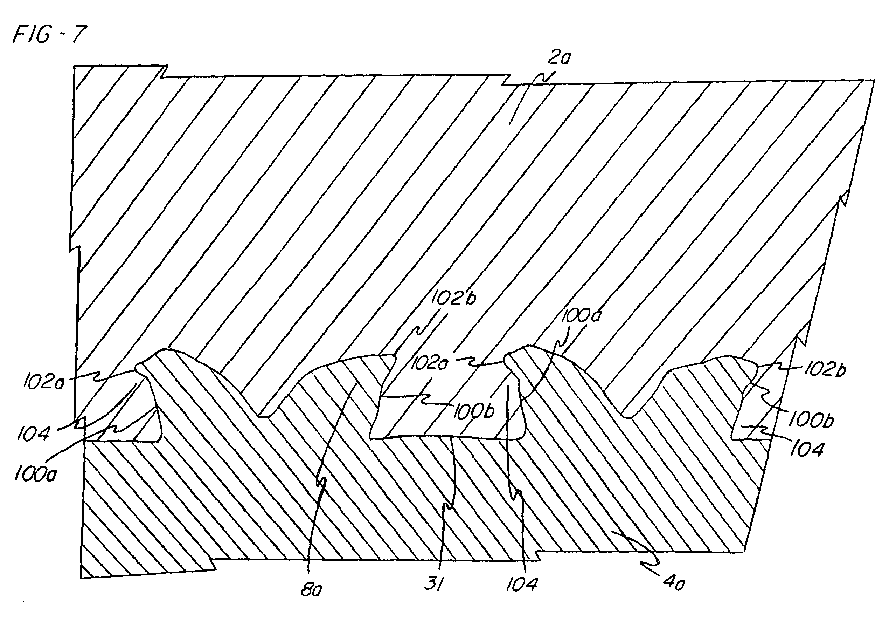

Turning now to figure 7, there is shown a magnified view of the target/backing plate interface at the area having salient portions or projections 8a after the target/backing plate assembly has been consolidated by the above low temperature/pressure step. As a result of the low temperature pressure consolidation step, the points or projections 8a deform and fold back toward the interfacial plane 31, providing a physical locking mechanism between the surfaces.

As shown in Figure 7, the deformed edge 100a of the "M" shaped projections, is bent toward the backing plate 4a as a result of the low temperature pressure consolidation. This edge 100a forms a re-entrant angle, as shown of about 55-60°, relative to the horizontal plane made along interfacial surfaces of the target and backing plate. The plane is shown generally in this figure as 31. The projections each contain a second bent edge 100b also forming a re-entrant angle relative to the horizontal plane. Due to bending of the edges 100a, 100b, the tips 102a, 102b of the projection adjacent edges 100a, 100b form a locking type joint, overlaying target material 104 and trapping target material 104 against separation forces or vectors that would act in shear or in a perpendicular direction relative to the plane 31. This forms a tenacious joint of backing plate and target.

The method and assembly have shown promise in bonding high-purity targets such as Al, Al-Cu, or Al-Cu-Si targets, to lower-purity backing members, such as Al 6061. Additionally, the method may also be employed to bond Cu targets and Cu containing alloy targets over 6061 Al or Cu metallurgies (Cu Alloys).

Turning now to Figs. 2 and 5, there is shown an example of a target/backing plate assembly made with the method of the invention. The second embodiment comprises a target 2b having a top side 23b and a bottom side 11b, and a backing plate 4b having a top side 13b adapted to mate with the bottom side 11b. The filler material 6 may optionally be provided adjacent the peripheral border 25 of the second embodiment between the target 2b and backing plate 4b.

A plurality of salient portions of projections 8b are formed on the harder of either one of the surfaces 11b or 13b. In this embodiment, the projections are formed on the underside of the target. Corresponding grooves 30b, adapted to receive the projections 8b, are formed in the other of the surfaces 11b or 13b; here, on the top side of the backing plate. The grooves 30b are formed by machining concentric circular grooves that angle radially inward toward the center of the target/backing plate assembly. Alternatively, the grooves 30b may angle radially outward.

The target 2b and backing plate 4b are joined together in the same manner as detailed above for the first embodiment.

As can be seen in Fig. 5, as a result of the low temperature pressure consolidation step, the projection 8b are deformed radially inward and fold back toward the surface 13b, thereby providing a physical locking mechanism between the surfaces 11b, 13b.

A second example of the target/backing plate assembly made by the method of the invention is shown in Figs. 3 and 6, wherein features corresponding to those of the first and second embodiments disclosed above are denoted by the same reference numerals having the suffix "c". As shown, alternate grooves 30c are formed so as to angle radially opposite each other so that, after the low temperature pressure consolidation step, the projections 8c are deformed or "splay" in opposite directions.

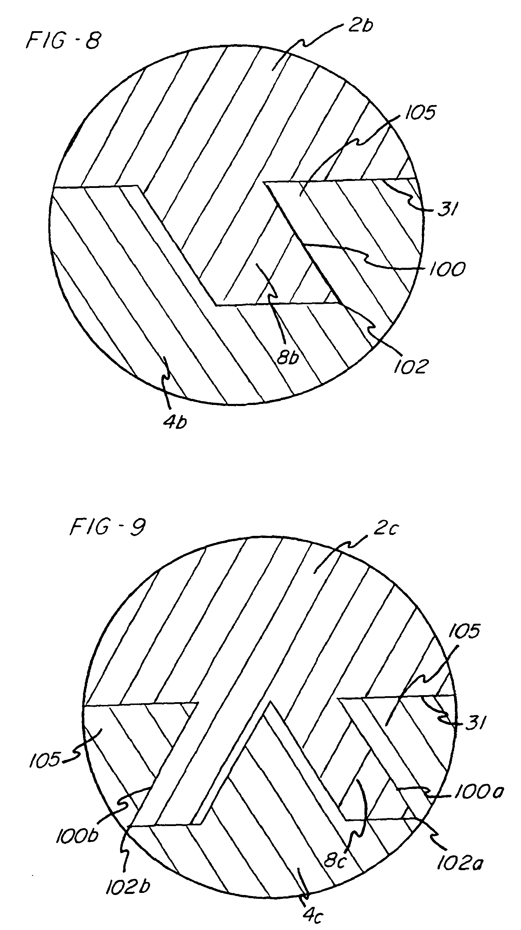

Turning now to Figure 8, the target/backing plate interface is shown for the Figure 2 target/backing plate joint structure. Here, the edge 100 of projection 8b forms a re-entrant angle ∝ relative to the plane of the surfaces of target 2b and backing plate 4b (i.e. plane 31) of about 60°. The tip 102 of the projection connected to edge 100 thereby locks or grips the backing plate material 105 to withstand mechanical and thermal forces that may otherwise act during sputtering to separate the assembly.

Figure 9 magnifies the target/backing plate joint or interface of Fig. 6, 2 having substantially "V" shaped projections 8c with deformed edges 100a, 100b each defining a re-entrant angle ∝ of about 60° relative to the horizontal mating plane of the target and backing plate. Tips 102a, 102b respectively of the projection form a locking joint trapping backing plate material 105 in a snug, interlocking joint structure.

The locking joint of the combination of sputter target and backing plate of the invention as clearly seen in Figure 7 can thereby be described as a joint formed between mating interfacial surfaces of the target and backing plate wherein the harder metal or alloy of either the target or backing plate member is provided with a projection. An edge of the projection is bent or deformed during the lower temperature/pressure consolidation so that it forms a re-entrant angle of less than 90° as measured from the mating plane formed between the target and backing plate. Preferably, this angle is on the order of about 35-80°.

The leading tip of the projection connected to this re-entrant edge thereby forms an angled lock or grip over the other metal to thereby resist shear and tensile forces that may otherwise tend to de-bond the assembly.

The invention will be further described in conjunction with the ensuing examples which are not to be construed as limitations to the inventions but instead are illustrative of specific embodiments of the invention.

### Example 1

An assembly of the invention of the type shown in Figure 1 was bonded in accordance with the method the invention. Target 2a was composed of high purity Al with the backing plate 4a composed of Al 6061. The projections 8a were provided in the backing plate 4a with each projection 8a having a height of about 0.05". A filler material 6 comprising Al-4%Si was positioned around the inside of the peripheral boundary of the assembly. The peripheral zone was E-beam welded under vacuum. Then, the assembly was pressure consolidated at room temperature such that the overall thickness of the assembly decreased by about 0.1".

### Example 2

An assembly not covered by the scope of claim 16 of the general type shown in Figure 2 was bonded in accordance with the method of the invention. Target 2b was composed of high purity Cu with the backing plate 4b composed of Cu-1%Cr. The projections were provided in the backing plate with each projection having a height of about 0.1". No filler material was used. The peripheral zone was E-beam welded under vacuum. Then, the assembly was pressure consolidated at room temperature such that the overall thickness of the assembly decreased by about 0.1".

While the methods described herein, and the target/backing plate assemblies produced in accordance with the methods, have been described with regard to certain specific forms and certain modifications thereof, it will be appreciated that a wide variety of other modifications can be made without departing from the scope of this invention as defined in the appended claims. It is also to be kept in mind that reference to a metal or metal component herein also includes reference to alloyed forms of the stated metal.

## Claims

1. A method of preparing a bonded sputter target/backing plate assembly comprising a target (2a, b, c) composed of a metal or alloy to be sputtered and an under-lying metallic backing plate member (4a, b, c) by joining said target and backing plate along mating surfaces (11a, b, c, 13a, b, c) thereof, said method comprising the steps of:
a) forming a plurality of projections (8a, b, c) in at least one of said mating surfaces (11b, c, 13a, b, c);
b) positioning said target and backing plate adjacent each other to form an assembly having an interface defined by said mating surfaces;
c) pressure consolidating said assembly,
**characterised in that** the pressure consolidating step is carried out under low temperature conditions of less than 38°C to join and bond said target and backing plate together with said projections penetrating into and mechanically locking over the other of said mating surfaces.

2. A method as recited in claim 1 wherein said assembly comprises a peripheral boundary (25) surrounding said projections and wherein said method comprises the additional step (d) of bonding said assembly proximate said peripheral boundary.

3. A method as recited in claim 2 wherein said step (d) is performed after said step (b) and before said step (c).

4. A method as recited in claim 3 wherein said step (d) comprises e-beam welding of said peripheral boundary.

5. A method as recited in claim 4 wherein said e-beam welding is carried out along an annular zone adjacent said peripheral boundary (2a).

6. A method as recited in claim 4 or claim 5 wherein said step (d) further comprises interposing a weldable filler material (6) between said target (2a, b, c) and said backing plate (4a, b, c) proximate said peripheral boundary (25).

7. A method as recited in claim 2 or claim 3 wherein said step (d) comprises friction welding.

8. A method as recited in claim 2 or claim 3 wherein said step (d) comprises TIG welding.

9. A method as recited in any preceding claim wherein said target (2a, b, c) is selected from Al, Cu, Ti, Co and their alloys.

10. A method as recited in claim 9 wherein said target (2a, b, c) comprises Al or an Al alloy.

11. A method as recited in claim 9 wherein said target comprises Cu or a Cu alloy.

12. A method as recited in any preceding claim wherein said backing plate comprises Al, stainless steel, Cu, Ti or their alloys.

13. A method as recited in any preceding claim further comprising the step (e) of low temperature annealing said pressure-consolidated assembly.

14. A method as recited in any preceding claim wherein the temperature of step (c) is about room temperature.

15. A method according to any preceding claim wherein said projections (8a, b, c) have at least one edge (100) and a projection tip (102) connected to said edge, and wherein the step (c) of consolidating said target and backing plate is carried out at a pressure sufficient to deform said edge or edges so that at least one edge forms a re-entrant angle of less than 90° relative to a plane defined by said mating surfaces (11a, b, c, 13a, b, c) and said projection tip extends into an opposed mating surface to form an angled, locking grip therein.

16. A combination comprising a sputter target (2a, b, c) and backing plate (4a, b, c), said target and backing plate mating along a plane defined by mating interfacial surfaces (11a, b, c, 13a, b, c) of each, a plurality of projections (8a, b, c) formed in one of said interfacial surfaces and having at least one edge (100a), **characterised in that** a projecting tip (102) is connected to said edge (100a), said edge (100a) being bent at a first re-entrant angle of less than 90° relative to said plane and said projecting tip (102) forming, with a second re-entrant edge (100b), a angled locking grip extending into and over the other of said interfacial surfaces.

17. A combination as recited in claim 17 further comprising a peripheral zone (25) surrounding said projections (8a, b, c) and a bondable filler material (6) positioned in said peripheral zone.

18. A combination as recited in claim 16 or claim 17 wherein said target (2a, b, c) comprises Cu.

19. A combination as recited in any one of claims 16 to 18 wherein said backing plate (4a) comprises Al alloy and said target comprises Al, said projections (8a) comprising substantially "M" cross sectioned ridges formed in said backing plate with said ridges provided along said interfacial surface of said backing plate in a plurality of concentrically arranged rows.

20. A combination as recited in any one of claims 16 to 19 wherein said projections (8a) include substantially "M" shaped cross-sectioned ridges and wherein said at least one edge (100a) is bent at an angle of 35-80°.

21. A combination as recited in any one of claims 16 to 18 wherein said projections include substantially "V" shaped cross-sectional ridges (8c), each said "V" shaped ridge having a pair of edges (100b) bent at re-entrant angles.

## Patentansprüche

1. Verfahren zur Vorbereitung eines verbundenen Sputter-Targets /Stützplattenanordnung bestehend aus einem Target (2a, b, c) zusammengesetzt aus einem Metall oder einer Legierung, welches gesputtet werden soll, und ein darunter liegendes metallisches Stützplattenmittel (4a, b, c) durch Verbindung des Targets und der Stützplatte entlang deren Kontaktoberflächen (11a, b, c,13a, b, c), das Verfahren weist folgende Schritte auf:
a) Bildung einer Vielzahl von Projektionen (8a, b, c) bei mindestens einer der Kontaktoberflächen (11a, b, c,13a, b, c);
b) Anordnung des Targets und der Stützplatte angrenzend zueinander, um eine Anordnung zu bilden, welche eine Berührungsfläche aufweist, welche durch die Kontaktoberfläche bestimmt ist;
c) Anschlussdruck zur Zusammenführung der Anordnung,
**dadurch gekennzeichnet, dass** der Schritt zur Zusammenführung mittels dem Anschlussdruck unter Niedrigtemperaturkonditionen von weniger als 38°C durchgeführt wird, um das Target und die Stützplatte mittels den Projektionen miteinander zu vereinigen und zu verbinden, wobei die Projektionen ineinander eingreifen und sich mechanisch mit der jeweils anderen Kontaktoberfläche verriegeln.

2. Verfahren nach Anspruch 1, worin die Anordnung periphere Ränder (25), welche die Projektionen umfassen und worin das Verfahren den zusätzlichen Schritt (d) zur Bindung der Anordnung in der Nähe des peripheren Randes aufweist.

3. Verfahren nach Anspruch 2, worin der Schritt (d) nach den Schritt (b) und vor den Schritt (c) durchgeführt wird.

4. Verfahren nach Anspruch 3, worin der Schritt (d) das Elektronenstrahlschweißen der peripheren Ränder aufweist.

5. Verfahren nach Anspruch 4, worin das Elektronenstrahlschweißen entlang einer ringförmigen Zone, benachbart zu dem peripheren Rand (2a) durchgeführt wird.

6. Verfahren nach Anspruch 4 oder 5, worin der Schritt (4) ferner die Einfügung eines schweißbaren Füllmaterials (6) zwischen den Target (2a, b, c) und der Stützplattenplatte (4a, b, c) in der Nähe des peripheren Randes (25) einschließt.

7. Verfahren nach Anspruch 2 oder 3, worin der Schritt (d) das Reibschweißen umfasst.

8. Verfahren nach Anspruch 2 oder 3, worin der Schritt (d) das Wolfram-Inertgas-Schweißen (WIG) einschließt.

9. Verfahren nach einem der vorangegangen Ansprüche, worin das Target (2a, b, c) aus den Materialien Al, Cu, Ti, Co und ihre Legierungen ausgewählt ist.

10. Verfahren nach Anspruch 9, worin das Target (2a, b, c) aus AL oder einer AL-Legierung besteht.

11. Verfahren nach Anspruch 9, worin des Target aus Cu oder einer Cu-Legierung besteht.

12. Verfahren nach einem der vorangegangen Ansprüche, worin die Stützplatte AL, Edelstahl, Cu, Ti oder ihre Legierungen umfasst.

13. Verfahren nach einem der vorangegangen Ansprüche, worin ferner der Schritt (e) das Niedrigtemperaturanlassen der Druck-Zusammenführung der Anordnung einschließt.

14. Verfahren nach einem der vorangegangen Ansprüche, worin die Temperatur im Schritt (10) ungefähr Zimmertemperatur ist.

15. Verfahren nach einem der vorangegangen Ansprüche, worin die Projektionen (8a, b, c) mindestens einen Rand (100) und mindestens eine mit dem Rand verbundene Projektionsspitze (102) aufweisen und worin der Schritt (c) die Zusammenführung des Targets mit der Stützplatte bei einem zur Deformation des Randes oder der Ränder hinreichenden Druck durchgeführt wird, so dass mindestens ein Rand einen Wiedereintrittswinkel von weniger als 90 Grad verhältnismäßig zu der Ebene aufweist, welche durch die Berührungsoberfläche (11a, b, c, 13 a, b, c) bestimmt ist und sich die Vorsprungsspitze in eine gegenüberliegende Berührungsoberfläche erstreckt, um einen angewinkelten, klammernden Eingriff darin zu bilden.

16. Kombination bestehend aus einem Sputter Target (2a, b, c) und einer Stützplatte (4a, b, c), das Target und die Stützplatte berühren sich entlang einer Ebene, welche durch eine Kontaktoberfläche (11a, b, c 13a, b, c) der beiden definiert ist, einer Vielzahl von Projektionen (8a, b, c) gebildet in einer der Kontaktoberflächen und mindestens einen Rand aufweisend (100a), **dadurch gekennzeichnet, dass** eine Projektionsspitze (102) mit dem Rand (100a) verbundenen ist, der Rand (100a) ist bei einem ersten Wiedereintrittswinkel von weniger als 90 Grad verhältnismäßig zur Ebene angewinkelt und die Projektionsspitze (102) bildet mit einem zweiten Wiedereintrittrand (100b), eine angewinkelte Verklammerung, welche sich in oder über die andere Schnittoberfläche hinaus erstreckt.

17. Kombination nach Anspruch 17, ferner eine periphere Zone (25) aufweist, welche die Projektionen (8a, b, c) umgibt und das verbindbare Füllmaterial (6), welches in der peripheren Zone angeordnet ist.

18. Zusammenstellung nach Anspruch 16 oder 17, worin das Target (2a, b, c) Cu umfasst.

19. Kombination nach einem der Ansprüche 16 bis 18, worin die Stützplatten (4a) einer Al-Legierung umfasst und das Target Al aufweist, die Projektionen (8a) weisen im Wesentlichen Rippen mit einem "M"-förmigen Querschnitt, welcher in die Stützplattenplatte gebildet ist mit Rippen, welche entlang der Schichtoberfläche der Stützplatten in einer Vielzahl von konzentrisch angeordneten Reihen angeordnet sind.

20. Kombination nach einem der vorangegangen Ansprüche 16 bis 19, worin die Projektionen (8a) im Wesentlichen Rippen von einem "M"-förmigen Querschnitt aufweisen, und worin mindestens ein Rand (100a) in einem Winkel von 35 bis 80 Grad abgekantet ist.

21. Kombination nach einem der vorangegangen Ansprüche 16 bis 18, worin die Projektionen im Wesentlichen Rippen (8c) mit im Wesentlichen "V"-förmigen Querschnitt aufweisen, wobei jede "V"-förmige Rippe ein Paar von Rändern (100b) aufweist, welche in einem Wiedereintrittswinkel abgekantet sind.

## Revendications

1. Procédé pour préparer un ensemble cible de pulvérisation/plaque arrière lié comprenant une cible (2a, b, c) composée d'un métal ou d'un alliage à pulvériser et d'un élément de plaque arrière métallique sous-jacent (4a, b, c) en joignant ladite cible et ladite plaque arrière le long de leur surface de contact (11a, b, c, 13a, b, c), ledit procédé comprenant les étapes de :
a) former une pluralité de projections (8a, b, c) dans au moins une desdites surfaces de contact (11b, c, 13a, b, c) ;
b) positionner ladite cible et ladite plaque arrière de façon adjacente l'une par rapport à l'autre pour former un ensemble ayant une interface définie par lesdites surfaces de contact ;
c) stabiliser la pression dudit ensemble,
**caractérisé en ce que** l'étape de stabilisation de pression est effectuée dans des conditions de basse température inférieures à 38°C pour joindre et lier ladite cible et ladite plaque arrière ensemble avec lesdites projections pénétrant dans et se verrouillant mécaniquement avec l'autre desdites surfaces de contact.

2. Procédé selon la revendication 1, dans lequel ledit ensemble comprend une limite périphérique (25) entourant lesdites projections et dans lequel ledit procédé comprend l'étape additionnelle (d) de lier ledit ensemble à proximité de ladite limite périphérique.

3. Procédé selon la revendication 2, dans lequel ladite étape (d) est effectuée après ladite étape (b) et avant ladite étape (c).

4. Procédé selon la revendication 3, dans lequel ladite étape (d) comprend une soudure par faisceau d'électrons de ladite limite périphérique.

5. Procédé selon la revendication 4, dans lequel ladite soudure par faisceau d'électrons est effectuée le long d'une zone annulaire adjacente à ladite limite périphérique (2a).

6. Procédé selon la revendication 4 ou 5, dans lequel ladite étape (d) comprend en outre d'interposer un matériau de remplissage soudable (6) entre ladite cible (2a, b, c) et ladite plaque arrière (4a, b, c) à proximité de ladite limite périphérique (25).

7. Procédé selon la revendication 2 ou 3, dans lequel ladite étape (d) comprend un soudage par friction.

8. Procédé selon la revendication 2 ou 3, dans lequel ladite étape (d) comprend un soudage TIG.

9. Procédé selon l'une quelconque des revendications précédentes, dans lequel ladite cible (2a, b, c) est sélectionnée parmi Al, Cu, Ti, Co et leurs alliages.

10. Procédé selon la revendication 9, dans lequel ladite cible (2a, b, c) comprend du Al ou un alliage de Al.

11. Procédé selon la revendication 9, dans lequel ladite cible comprend du Cu ou un alliage de Cu.

12. Procédé selon l'une quelconque des revendications précédentes, dans lequel ladite plaque arrière comprend du Al, de l'acier inoxydable, du Cu, du Ti ou leurs alliages.

13. Procédé selon l'une quelconque des revendications précédentes, comprenant en outre l'étape (e) de recuire à base température ledit ensemble à pression stabilisée.

14. Procédé selon l'une quelconque des revendications précédentes, dans lequel la température de l'étape (c) est à peu près une température ambiante.

15. Procédé selon l'une quelconque des revendications précédentes, dans lequel lesdites projections (8a, b, c) ont au moins un bord (100) et un bout de projection (102) connecté audit bord, et dans lequel l'étape (c) de stabiliser ladite cible et ladite plaque arrière est effectutée à une pression suffisante pour déformer ledit ou lesdites bord(s) de sorte qu'au moins un bord forme un angle rentrant inférieur à 90° par rapport à un plan défini par lesdites surfaces de contact (11a, b, c, 13a, b, c) et ledit bout de projection s'étend dans une surface de contact opposée pour former à l'intérieur une bride de verrouillage inclinée.

16. Combinaison comprenant une cible de pulvérisation (2a, b, c) et une plaque arrière (4a, b, c), ladite cible et ladite plaque arrière étant en contact le long d'un plan défini par des surfaces d'interfaces de contact respectives (11a, b, c, 13a, b, c), une pluralité de projections (8a, b, c) formées dans une desdites surfaces d'interface et ayant au moins un bord (100a), **caractérisée en ce qu'**un bout de projection (102) est connecté audit bord (100a) ledit bord (100a) étant plié selon un premier angle rentrant inférieur à 90° par rapport audit plan et ledit bout de projection (102) formant, avec un second bord rentrant (100b), une bride de verrouillage inclinée s'étendant dans et sur l'autre desdites surfaces d'interfaces.

17. Combinaison selon la revendication 16, comprenant en outre une zone périphérique (25) entourant lesdites projections (8a, b, c) et un matériau de remplissage apte à se lier (6) positionnée dans ladite zone périphérique.

18. Combinaison selon la revendication 16 ou 17, dans laquelle ladite cible (2a, b, c) comprend du Cu.

19. Combinaison selon l'une quelconque des revendications 16 à 18, dans laquelle ladite plaque arrière (4a) comprend un alliage de Al et ladite cible comprend du Al, lesdites projections (8a) comprenant des nervures sensiblement en forme de « M » en section transversale formées dans ladite plaque arrière avec lesdites nervures prévues le long de ladite surface d'interface de ladite plaque arrière selon une pluralité de rangées disposées de façon concentrique.

20. Combinaison selon l'une quelconque des revendications 16 à 19, dans laquelle lesdites projections (8a) comportent des nervures sensiblement en forme de « M » en section transversale et dans laquelle ledit au moins un bord (100a) est incliné selon un angle de 35 à 80°.

21. Combinaison selon l'une quelconque des revendications 16 à 18, dans laquelle lesdites projections comportent des nervures sensiblement en forme de « V » en section transversale (8c), chaque dite nervure en forme de « V » ayant une paire de bords (100b) inclinés selon des angles rentrants.
